# EUROPEAN PATENT APPLICATION

(11) **EP 4 560 687 A1**
(43) Date of publication of application: **28.05.2025**
(21) Application number: 24214507.6
(22) Date of filing: 21.11.2024
(51) Int. Cl.: H01L 21/683, H01L 21/768, H01L 23/528, H01L 25/065, H01L 25/18

(54) **SYSTEM AND METHODS FOR A BACKSIDE PACKAGE ARCHITECTURE**

(30) Priority: 22.11.2023 US 202363602363 P; 16.08.2024 US 202418807904
(71) Applicant: Samsung Electronics Co., Ltd., Suwon-si, Gyeonggi-do 16677 (KR)
(72) Inventor: YANG, Jin, San Jose, CA 95134 (US); KIM, WooPoung, San Jose, CA 95134 (US)
(74) Representative: Kuhnen & Wacker Patent- und Rechtsanwaltsbüro PartG mbB

(57) **Abstract**

A method, system, and device are disclosed herein where a first layer includes at least one transistor, a second layer on a first side of the first layer includes a signal network, a third layer on a second side of the first layer, opposite the first side, includes a backside power delivery network, and a memory module is coupled to the signal network. The backside power delivery network, the at least one transistor, and the signal network may provide a logic circuit for the memory module.

## Description

### TECHNICAL FIELD

The subject matter disclosed herein relates to microelectronics packaging and integrated circuits (IC) packaging. More particularly, the subject matter disclosed herein relates to a package architecture involving the configuration of backside power networks.

### BACKGROUND

Semiconductor devices may connect to additional devices and circuitry on different substrates. Forming connections between substrates can provide increased computation. However, forming connections between substrates can cause difficulties. Packaging describes the general method for connecting and integrating multiple computational components together in an integrated unit, and may involve multiple different types of integrated circuits on multiple substrates which may combine into a single unit. It is further noted that background concepts discussed herein are for informational purposes only and are not intended to limit the present disclosure. Nor should the background or field described herein be intended to limit the disclosure herein to a particular use or concept.

### SUMMARY

An example embodiment provides a device including a first layer having at least one transistor, a second layer on a first side of the first layer, the second layer including a signal network, a third layer on a second side of the first layer, the second side opposite the first side, the third layer including a backside power delivery network, and a memory module coupled to the signal network. In some embodiments, the memory module includes at least one dynamic random access memory die. In some embodiments, the at least one dynamic random access memory die may include at least one core memory die. In some embodiments, the signal network is between the first layer and the memory module, and the signal network communicatively couples the first layer and the memory module. In some embodiments, a redistribution layer is between the signal network and the memory module. In some embodiments, the redistribution layer includes at least one through-bonding via. In some embodiments, the backside power delivery network provides power to the memory module. In some embodiments, the signal network provides packet routing signals to the memory module. In some embodiments, backside power delivery network, the at least one transistor, and the signal network together may provide a logic circuit for the memory module.

An example embodiment provides a system including a substrate having a first side and a second side opposite the first side, a transistor layer may be on the first side of the substrate, the transistor layer including at least one transistor. A signal network may be on the transistor layer, and the signal network may be communicatively coupled to the transistor layer. A backside power delivery network may be on the second side of the substrate, the backside power delivery network electrically coupled to the transistor layer, and backside power delivery network, the transitory layer, and the signal network together may provide a logic circuit for the memory module. In some embodiments, the memory module includes at least one high bandwidth memory die. In some embodiments, the at least one high bandwidth memory die includes at least one core memory die. In some embodiments, the memory module is mounted on the substrate. In some embodiments, a redistribution layer is between the signal network and the memory module. In some embodiments, the redistribution layer may include at least one through-bonding via.

An example embodiment provides a method including forming a transistor layer on a first side of a first substrate, the transistor layer including at least one transistor; forming a signal network layer on the transistor layer, the signal network layer communicatively coupled to the transistor layer; forming a backside power delivery network layer on a second side of the first substrate, the second side opposite the first side, the backside power delivery network layer electrically coupled to the transistor layer; bonding a memory module to the signal network layer; and attaching the backside power delivery network to a second substrate. In some embodiments, the memory module is at least one high bandwidth memory die. In some embodiments, bonding a memory module to the signal network layer includes forming a redistribution layer on the signal network layer and bonding the memory module to the redistribution layer. In some embodiments, bonding the memory module to the redistribution layer includes a hybrid bonding process. In some embodiments, prior to forming the backside power delivery network, the second side of the first substrate is partially removed.

### BRIEF DESCRIPTION OF THE DRAWING

In the following section, the aspects of the subject matter disclosed herein will be described with reference to exemplary embodiments illustrated in the figures, in which:
FIG. 1A depicts an enlarged cross-section view of an example embodiment of a packaging structure according to various embodiments of the subject matter disclosed herein;
FIG. 1B depicts a full cross-section view of an example embodiment of a packaging structure according to various embodiments of the subject matter disclosed herein;
FIG. 2A depicts an enlarged cross-section view of an example embodiment of a packaging structure according to various embodiments of the subject matter disclosed herein;
FIG. 2B depicts a full cross-section view of an example embodiment of a packaging structure according to various embodiments of the subject matter disclosed herein;
FIG. 3A depicts a cross-section view of an example embodiment of a packaging structure assembly at a first time according to various embodiments of the subject matter disclosed herein;
FIG. 3B depicts a cross-section view of an example embodiment of a packaging structure assembly at a second time according to various embodiments of the subject matter disclosed herein;
FIG. 3C depicts a cross-section view of an example embodiment of a packaging structure assembly at a third time according to various embodiments of the subject matter disclosed herein;
FIG. 3D depicts a cross-section view of an example embodiment of a packaging structure assembly at a fourth time according to various embodiments of the subject matter disclosed herein;
FIG. 3E depicts a cross-section view of an example embodiment of a packaging structure assembly at a fifth time according to various embodiments of the subject matter disclosed herein;
FIG. 3F depicts a cross-section view of an example embodiment of a packaging structure assembly at a sixth time according to various embodiments of the subject matter disclosed herein;
FIG. 3G depicts a cross-section view of an example embodiment of a packaging structure assembly at a seventh time according to various embodiments of the subject matter disclosed herein;
FIG. 3H depicts a cross-section view of an example embodiment of a packaging structure assembly at an eight time according to various embodiments of the subject matter disclosed herein;
FIG. 3I depicts a cross-section view of an example embodiment of a packaging structure assembly at a ninth time according to various embodiments of the subject matter disclosed herein;
FIG.4 depicts a cross-section view of an example embodiment of a packaging structure assembly according to various embodiments of the subject matter disclosed herein; and
FIG. 5 depicts an example embodiment of a method of forming a package structure according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein substrates may refer to a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination. Bonding substrates may be thus known in some embodiments as die-to-die (D2D) bonding, wafer-to-wafer bonding (W2W) or die-to-wafer bonding (D2W). In some embodiments, the substrates may contain circuits such as integrated circuits including central processing units (CPUs), logic chips, memory such as static random-access memory (SRAM), dynamic random-access memory (DRAM), synchronous dynamic random-access memory (SDRAM), double data rate DRAM or DDR DRAM, application processors (AP), graphical processing units (GPUs), other forms of auxiliary processing units (xPU), Artificial intelligence (AI) chips, High bandwidth memory (HBM) interfaces, and other application-specific integrated circuits (ASIC). In some embodiments, a combination of circuits may be present on a substrate. In some embodiments, a substrate may include a packaged chip.

As used herein, high bandwidth memory or HBM, may refer to a chip structure including one or more HBM modules. In some embodiments, the HBM may be manufactured by an advanced silicon node process.

As used herein packaging refers to a process of forming interconnections between substrates. In some embodiments, the interconnections may be between direct surfaces and involve W2W, D2D, and D2W bonding. In other embodiments, techniques including wire bonding and other forms of indirect bonding may be performed alone or in combination with W2W, D2D, and D2W bonding. In some embodiments, circuits may be bonded directly facing each other, while in other embodiments a flip-chip bonding may be used. In some embodiments, interconnections may be made between substrates on a front or circuit side of the substrate. In other embodiments, interconnections may be made on a rear or back side of the substrate opposite from the circuit structure. In some embodiments, an interconnection may include through-silicon vias (TSVs) or other forms of through-chip vias where one or more substrates may be connected using a via traveling through an interposer such as another substrate or chip. In some embodiments, an interconnection may be formed using connections on a surface of a substrate, such as a pad, and may use additional materials between the pads such as solder to form an interconnection.

As used herein, conductors may refer to a variety of conductive materials, including which materials may be used alone or in combination with other materials such as in the form of an alloy. In some embodiments the conductor is copper (Cu). In some embodiments, copper (Cu) may be in the form of Cu (II), Cu (III) or other forms of copper, alone or in combination with additional elements, including cobalt (Co) and ruthenium (Ru). Such a listing of elements is not intended to be exhaustive, and in other embodiments, any known other type of conductive material may be used.

As used herein, a System-on-a-chip or SOC refers to an integrated circuit that integrates most or all components of a computer into a single die. In some embodiments, the components may include on-chip CPU, memory interfaces, input/output (I/O) devices and interfaces, secondary storage interfaces, and may include other components such GPUs. In some embodiments a SOC may contain digital, analog, mixed-signal, and radio frequency signal processing functions. In some embodiments, the SOC may be manufactured by processes including an advanced silicon node process.

Disclosed herein are various embodiments of devices, systems and methods related to packaging architecture to combine backside power delivery networks (BSPDN), signal networks, and various forms of high bandwidth memory, including Joint Electron Device Engineering Council (JEDEC) standard HBM and non-JEDEC standard HBM. In some embodiments, other forms of DRAM may be used, including both SDRAM and other forms including DDR DRAM. In some embodiments, a BSPDN may be formed on the backside of a substrate, with a signal network formed on the front side of the same substrate. In some embodiments, the BSPDN and signal network may be formed on separate substrates and transferred to the same substrate. The BSPDN and signal network may be separated by a transistor layer. The transistor layer may include a plurality of transistors. The transistors may provide different functions and take different forms, including a logic layer. The BSPDN and signal network may form a single monolithic structure on the same die in a semiconductor foundry process. A memory module may be formed in a separate semiconductor foundry process, the same semiconductor foundry process, or may have multiple components formed in multiple semiconductor foundry processes and assembled in a packaging assembly process.

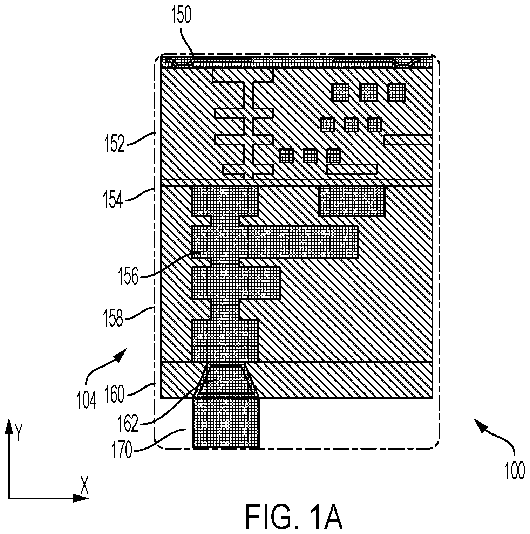

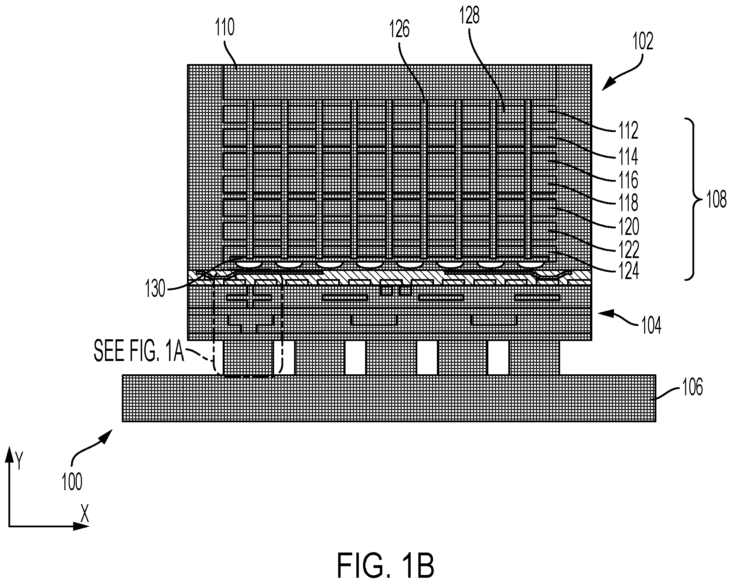

FIG. 1A and FIG. 1B depict an exemplary embodiment of a package architecture 100 which integrates a chip using backside power delivery with stacked memory, a memory module 102 is coupled with a base chip 104 with power and signal layers and mounted on a supporting substrate 106. An example embodiment of the base chip 104 is further shown in an expanded view in FIG. 1A, while FIG. 1B provides a wider view showing the memory module 102 coupled with the base chip 104. In the example embodiment of FIG. 1A and FIG 1B, the memory module 102 includes a DRAM core die 110 and a plurality of HBM 108 stacked vertically, including a first HBM 112, a second HBM 114, a third HBM 116, a fourth HBM 118, a fifth HBM 120, a sixth HBM 122, and a seventh HBM 124. In other embodiments, the number and type of dies, modules, and chips may vary, and may include additional dies and forms of chips, including processors, memory, and other forms of integrated circuits. Encapsulation material 128 may be provided between each of the plurality of HBM 108 to hold each individual HBM in place, as well as to control both thermal and electrical conduction. The encapsulation material 128, which may include materials such as an epoxy molding compound,, adhesive, resin or any other known dielectric materials, may further surround the lateral sides of the memory module 102. The plurality of HBM 108 may be electrically connected via a set of vias 126 to the DRAM core die 110. The DRAM core die 110 may act as a core die, or core memory device for the memory module 102. As used herein, a core device may refer to a individual device used in a multi-core architecture where multiple independent devices may be used together in a single integrated circuit. In some embodiments, a core device may be a processing device, in some embodiments, a core device may be a memory device. The vias 126 may further connect to an interface structure 130, which may be comprised of various forms of connections such as pads and bumps. The interface structure 130 may include a conductive connection, such as a bumps, microbumps, pillars, balls, and other forms such as controlled-collapse chip connection (C4) bumps, alone or in combination. As used herein, a C4 bump refers to a form of solder bumps placed on pads on a top surface of a substrate prior to flipping the substrate to form a flip-chip. The interface structure 130 may further include a dielectric material, which may include a material such as an adhesive, resin, or elastomer which may form a connection between the memory module 102 and the base chip 104 in addition to a conductive connection. In some embodiments, the combination of a conductive connection and a dielectric connection may form a hybrid bond.

The interface structure 130 couples the memory module 102 to the base chip 104 at a redistribution layer 150. The redistribution layer 150 is coupled to a signal network layer 152, which is in turn coupled to a transistor layer 154. The redistribution layer 150 may include a series of pads, lines, traces, and other forms of connection forming the top surface of the base chip 104. The redistribution layer 150 allows for connections between the memory module 102 and the base chip 104 to be spread out from where lines and vias may emerge on the surface of the signing section, allowing additional space for the connections to be formed, as well as providing additional space to prevent inadvertent connections. The signal network layer 152 may comprise a network-on-a-chip (NOC), and may provide interconnections to transport signals to and from the memory module 102. In some embodiments, the signal network layer 152 may provide packet routing. In some embodiments, the signal network layer 152 may comprise a plurality of layers, including multiple layers providing signal routing. In some embodiments, the signal network layer 152 may comprise a plurality of conductive channels within a dielectric material, and the plurality of conductive channels may be arranged in multiple layers, with the size of the conductive channels decreasing in distance from the transistor layer 154. In some embodiments, the signal network layer 152 may have a plurality of conductive channels in 4, 8, 10, 12 or more layers. In some embodiments, the conductive channels may include a conductive material such as a metal, including copper, aluminum, tungsten, alloys thereof, or any other known suitable conductive material alternatively or in addition, the conductive materials may include various forms of other conductive materials, including doped carbon, as well as conductive nanotubes. In some embodiments, the size of the conductive channels in a top layer of the signal network layer 152 may be substantially the same size as conductive channels of the HBM.

The transistor layer 154 separates the signal network layer 152 from a BSPDN layer 158 and the transistor layer 154 includes a plurality of transistors. As used herein, the transistor layer 154 may be used to refer to both the layer containing the plurality transistors and the plurality of transistors. In some embodiments, the transistor layer 154 may act as a base logic for both the signal network layer 152 and the BSPDN layer 158. As used herein, basic logic may refer to a logic circuit providing routing of communication signals and power signals. In other embodiments, the transistor layer 154 along with the signal network layer 152 and the BSPDN layer 158 provide the base logic for the memory module 102. The BSPDN layer 158 provides a power delivery network for routing power supply lines 156 on the back side of the transistor layer 154 and may provide both power and reference voltages to transistors in transistor layer 154. The BSPDN layer 158 may include multiple different layers of power supply lines 156 routing power within an insulating material. In some embodiments the insulating material may include a dielectric material. In some embodiments, the BSPDN layer 158 may include 15 to 20 layers of the power supply lines 156, while in other embodiments, the number of layers of the power supply lines 156 may vary, and include more than 20 or less than 15 layers. In some embodiments, the size of the power supply lines 156 may decrease as they approach the transistor layer 154. The power supply lines 156 may be comprised of conductive materials, including various forms of low resistive metals, such as copper, aluminum, tungsten, alternatively or in addition, the conductive materials may include various forms of other conductive materials, including doped carbon, as well as conductive nanotubes.

A power substrate layer 160 forms the bottom of the BSPDN layer 158 and includes a via with a plug 162 to couple the BSPDN layer 158 to the supporting substrate 106 with an interconnect 170. In some embodiments, a plurality of plugs and vias may be used to connect couple the BSPDN layer 158 to the supporting substrate 106. The interconnect 170 may include conductive connections including pads, bumps, microbumps, pillars, balls, and other forms such as C4 bumps, as well as any other form of conductive connection alone or in combination. Furthermore, the interconnect 170 may include a dielectric connection, such as a dielectric material, which may include a material such as an adhesive, resin, or elastomer which may form a dielectric connection in addition to a conductive connection. In some embodiments, the combination of a conductive connection and a dielectric connection may form a hybrid bond. The supporting substrate 106 may in turn connect to other devices and dies, and in some embodiments, may take the form of an interposer supporting multiple devices and dies on an additional substrate such as a circuit board. In some embodiments, the supporting substrate 106 may support multiple sets of the memory module 102 on the base chip 104.

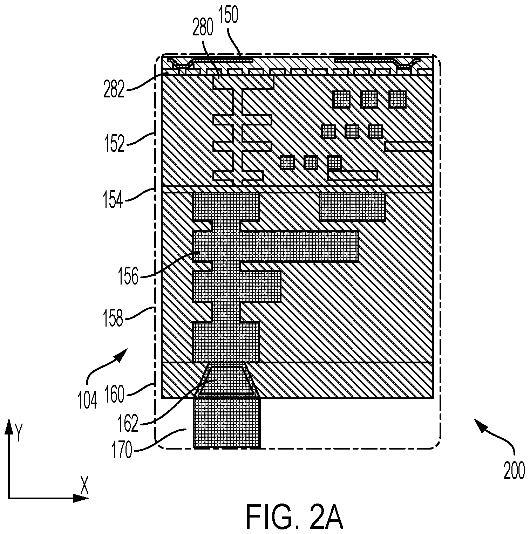

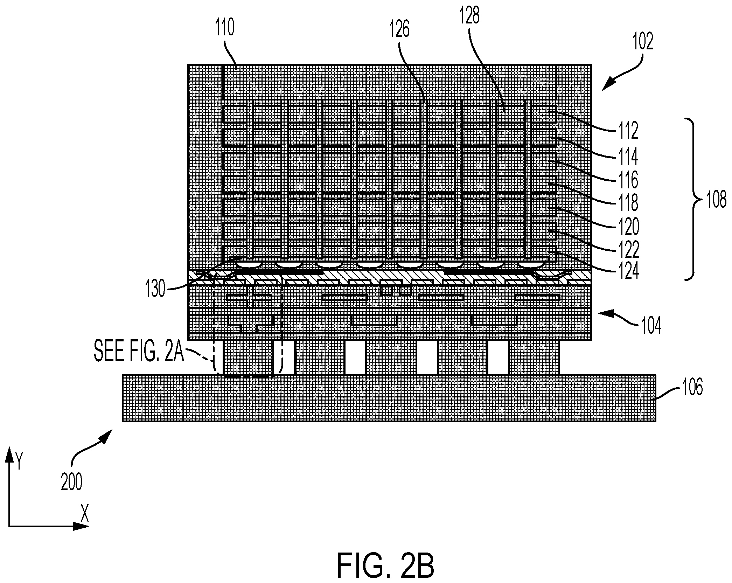

FIG. 2A depicts an enlarged view an exemplary embodiment of a package architecture 200 which integrates a chip using backside power delivery with stacked memory. FIG 2B, in turn, provides an overview of the module for the package architecture 200. The package architecture 200 differs from the package architecture 100 as shown in FIG. 1A and FIG. 1B by including an additional layer of through-bonding vias 280 on the surface of the base chip 104 below the redistribution layer 150. The through-bonding vias 280 are formed within a bonding layer 282 on the surface of the signal network layer 152. The bonding layer 282 may comprise a dielectric material such as silicon oxide, SiO₂, silicon nitride, SiN, or other semiconductor material formed on the signal network layer 152 prior to the formation of the redistribution layer 150. The through-bonding vias 280 may be formed in the bonding layer 282 to connect between the redistribution layer 150 to the signal network layer 152. The through-bonding vias 280 thus may provide an additional dimension of depth for bonding the base chip 104 to the memory module 102, and may expose dielectric materials in the bonding layer 282. In some embodiments, through-bonding vias 280 may enable the use of hybrid bonding techniques to bond the base chip 104 to the memory module 102, as both dielectric and metal surfaces of the signal network layer 152 may be exposed, and thus bonded to corresponding dielectric and metal surfaces on the memory module 102. A hybrid bonding technique may be used to provide additional connections between opposing surfaces, allowing both dielectric and conductive surfaces bond, and increase the mechanical strength of the resulting structure.

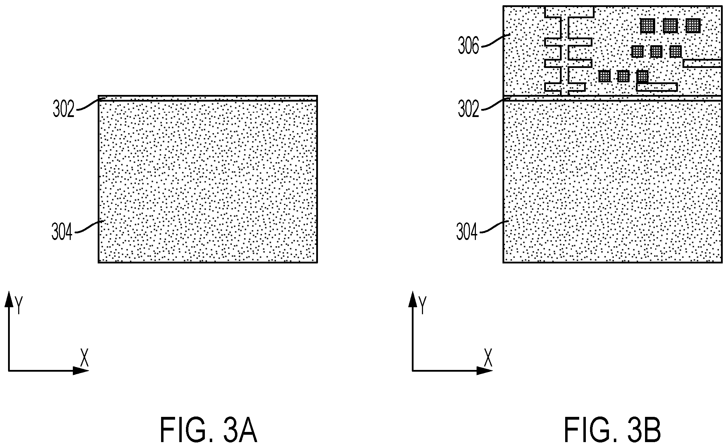

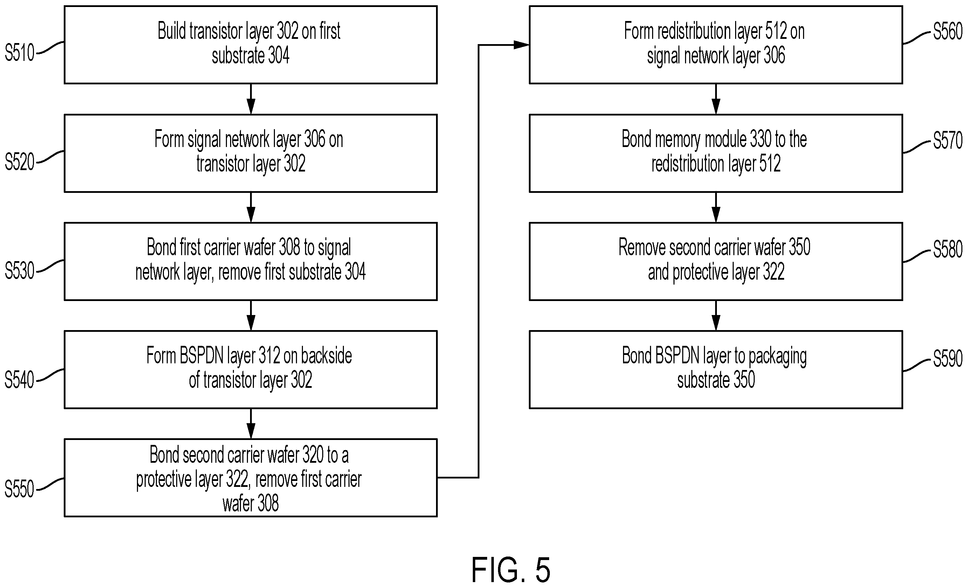

FIGS. 3A-3I depict an illustrative embodiment of the packaging process of an assembly 300. FIG. 5 depicts an example embodiment of a process 500 for forming a package structure corresponding to the illustrative embodiment of FIGS. 3A-3I. The assembly 300 may take the form of the package architecture 100 or the package architecture 200.

FIG. 3A shows at S510 in FIG. 5 where a transistor layer 302 is formed on a first substrate 304. The transistor layer 302 may be formed using complementary metal-oxide-semiconductor (CMOS) processes, such as deposition, doping, lithography, etching, passivation, etc. as well as other known processes to form transistors. In some embodiments, the transistors may be formed by depositing semiconductor materials on the first substrate 304, doping the semiconductor materials to form a bandgap, using lithographic and etching processes to shape the semiconductor material, and providing passivation processes to protect the materials. However, in other embodiments, the transistors may be formed using different processes, on the first substrate 304, or within the first substrate 304, or may be formed on an additional substrate and transferred to the first substrate 304. In some embodiments, the first substrate 304 may be a silicon wafer, while in other embodiments, the first substrate 304 may include other semiconductor materials such as germanium, or may take the form of other substrates such as an organic substrate or even a SOI substrate such as glass. In some embodiments, the first substrate 304 may be a sacrificial substrate, with the substrate intended to be partially or fully destroyed during the packaging process. In other embodiments, the first substrate 304 may be a carrier substrate, and may include an adhesive layer formed on the surface of the first substrate 304 prior to the formation of the transistor layer 302. An adhesive layer may be formed to allow the first substrate 304 to separate from the transistor layer 302 upon using one or more of layer release, chemical release, thermal release, or photo release techniques to release the adhesive layer coupling the transistor layer 302 to the first substrate 304. The transistor layer 302 and structures built directly on the transistor layer 302 may be referred to as front-side layers.

FIG. 3B shows at S520 in FIG. 5 the formation of a signal network layer 306 on the transistor layer 302. The signal network layer 306 may be formed using CMOS processes to build the various conductive, dielectric and insulative portions of the signal network layer 306 directly on to the transistor layer 302. Alternatively, in some embodiments, the signal network layer 306 may be fully formed on a separate substrate before being transferred to the first substrate 304 and bonded directly to the transistor layer 302.

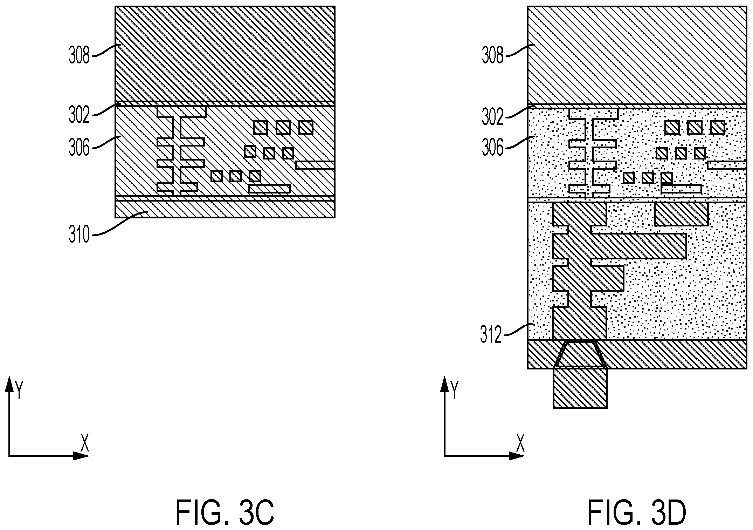

FIG. 3C shows at S530 in FIG. 5 a first carrier wafer 308 bonded to the signal network layer 306. The first substrate 304 may then be fully or partially removed, with FIG. 3C showing a remaining portion 310 of the first substrate 304, also referred herein as a remaining substrate layer 310, present on the transistor layer 302. The first substrate 304 may be fully or partially removed using a variety of processes, including or more grinding, polishing, etching, and peeling processes, including chemical mechanical polishing (CMP). The remaining substrate layer 310 may be planarized to provide a flat surface suitable for additional CMOS processing. The first carrier wafer 308 may be bonded, for example, using an adhesive layer to direct bond to the signal network layer 306. In some embodiments, the first carrier wafer 308 may serve as a carrier wafer, and may be suitable for uses in temperatures up to a temperature threshold. For example, in some embodiments, a temperature threshold may be about 400 °C, while in other embodiments the temperature threshold may be higher or lower.

FIG. 3D shows at S540 in FIG. 5 a BSPDN layer 312 formed on the backside of the transistor layer 302. In some embodiments, the BSPDN layer 312 is formed using CMOS processing. The BSPDN layer 312 may be formed by building directly on the backside of the transistor layer 302 by depositing additional materials on the remaining substrate layer 310, or may be formed in the remaining substrate layer 310 by conducting patterning steps such as lithography and etching to build trenches, vias, and holes within the remaining substrate layer 310, In some embodiments, the BSPDN layer 312 may be formed by both building directly on the remaining substrate layer 310 and conducting patterning steps to build within the remaining substrate layer 310. In some embodiments, multiple BSPDN layers may be formed with each layer stacking on the previous layer. In some embodiments, the BSPDN may be produced on a separate substrate and transferred to the backside of the transistor layer 302.

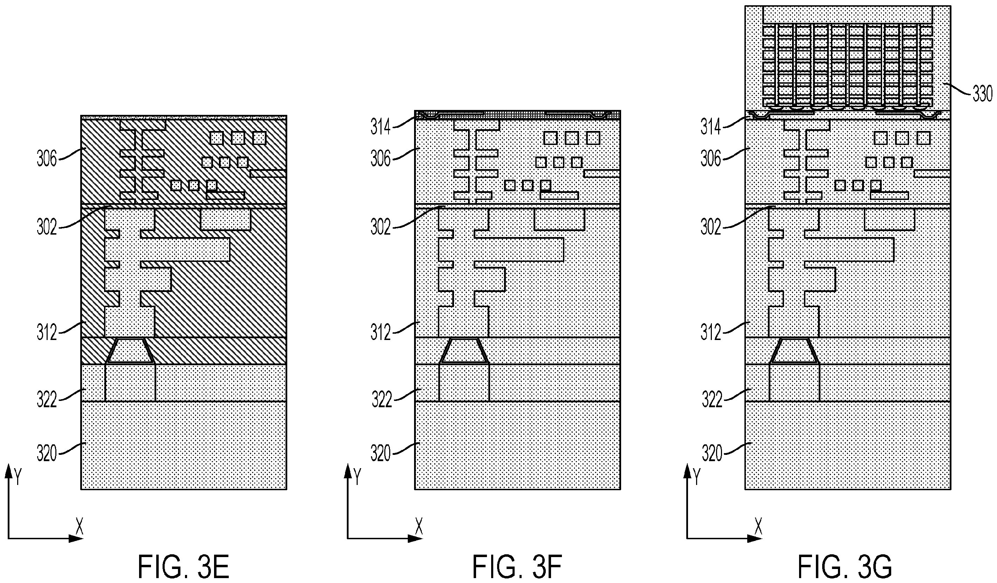

FIG. 3E shows at S550 in FIG. 5 the bonding of a second carrier wafer 320, and the removal of the first carrier wafer 308. A protective layer 322 may be deposited on the BSPDN layer 312 prior to bonding the second carrier wafer 320. The first carrier wafer 308 may be removed, for example, by using one or more of layer release, chemical release, thermal release, or photo release techniques to release an adhesive layer coupling the first carrier wafer 308 to the signal network layer 306. For example, in some embodiments a chemical release technique may use a solvent to dissolve the adhesive directly, while a thermal release technique may apply heat to the carrier wafer to melt the adhesive, and a photo release technique may use lasers to directly apply energy to the adhesive layer to reduce the adhesive strength. The protective layer 322 may be an oxide layer such as SiO_{2,}, aluminum oxide, Al₃O₂, titanium oxide, TiOz, or any other known suitable oxide, formed over the exposed surface of the BSPDN layer 312 to protect the BSPDN layer 312 during the assembly process. For example, the protective layer 322 may provide protection against exposure to oxygen for exposed metal portions of the BSPDN layer 312. The protective layer 322 may also provide protection against thermal, physical and electrical shock during the assembly process. Additionally, the second carrier wafer 320 may be bonded using an adhesive which protective layer 322 may prevent from damaging the BSPDN layer 312, and may provide a quick release layer. In some embodiments, the second carrier wafer 320 may be a low temperature carrier wafer for use in processing temperatures below a temperature threshold. In some embodiments, the temperature threshold may be 400 °C, while in other embodiments the threshold may be higher or lower.

FIG. 3F shows at S560 in FIG. 5 the formation of the redistribution layer 314 on the signal network layer 306. The redistribution layer 314 may be formed on the surface of the signal network layer 306, or may optionally use through-bonding vias penetrating into the surface of the signal network layer 306. In some embodiments, the redistribution layer 314 may be formed by a combination of processes including, for example, deposition, lithography and etching or any other suitable semiconductor processing technique, and may be performed as part of an in-line wafer process, also known as a front-end-of-line process (FEOL). A FEOL process is performed during the initial fabrication of an integrated circuit, where the device components are formed during the patterning of a semiconductor substrate. In some embodiments, the redistribution layer 314 may be formed by a back-end-of-line process (BEOL), and may be performed during packaging assembly. A BEOL process may refer to a process performed after the initial formation of an integrated circuit, where additional layers are formed on top of a previously formed integrated circuit.

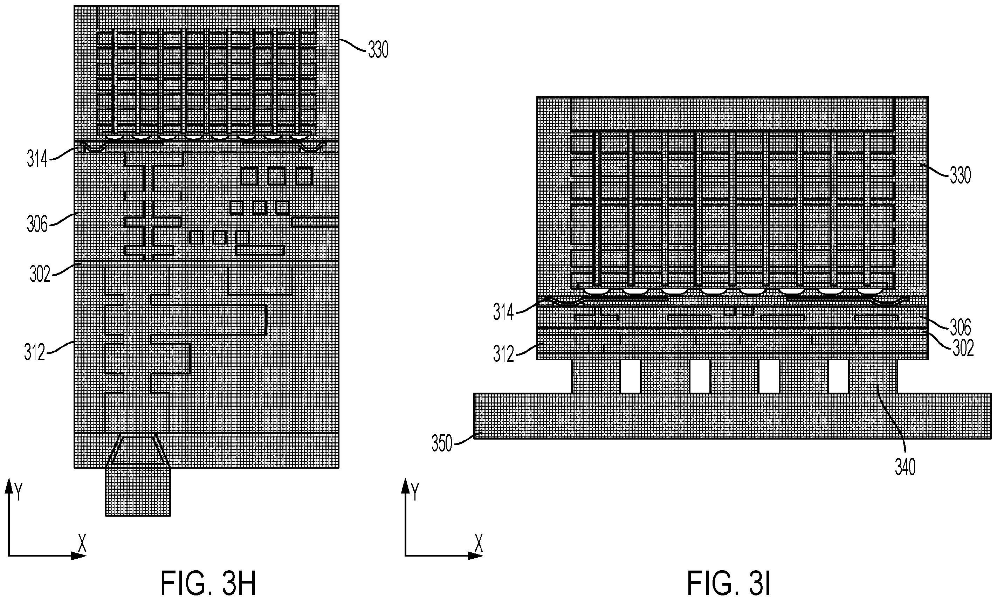

FIG. 3G shows at S570 in FIG. 5 the memory module 330 is bonded to the redistribution layer 314 on the signal network layer 306 to form an interconnection, In FIG. 3, the memory module 330 may correspond to the memory module 102 in FIGS. 1A-1B and the memory module 202 in FIGS. 2A-2B. In some embodiments, the bonding process may take place during a package assembly process, as part of a BEOL process where a completed memory module 330 is placed on the redistribution layer 314, and in some embodiments, may involve being transferred from an additional substrate. The memory module 330 may be separately produced in a separate FOEL process, where the memory module 330 may be manufactured on one or more additional substrates using CMOS processes. In some embodiments, the interconnection may include bonding between conductive materials at a surface of a substrate, as well as bonding between dielectric materials on a surface of a substrate. In some embodiments, the bonding process may use a hybrid bonding process in which both the dielectric and conductive regions are bonded together.

FIG. 3H shows at S580 in FIG. 5 the second carrier wafer 320 and the protective layer 322 removed from the BSPDN layer 312. The second carrier wafer 320 may be removed, for example, by using one or more of layer release, chemical release, thermal release, or photo release techniques to release an adhesive layer coupling the second carrier wafer 320 to the BSPDN layer 312. For example, in some embodiments a chemical release technique may use a solvent to dissolve the adhesive directly, while a thermal release technique may apply heat to the carrier wafer to melt the adhesive, and a photo release technique may use lasers to directly apply energy to the adhesive layer to reduce the adhesive strength.

FIG. 3I shows at S590 in FIG. 5 the assembled structure in place on a packaging substrate 350 using interconnection 340. The packaging substrate 350 may be another die, an interposer, inorganic or organic substrate. In some embodiments, the packaging substrate 350 may be a silicon interposer connecting the assembly 300 to additional components, such as a CPU or GPU, as part of a larger structure such as a graphic card. The interconnection 340 may include pad, bumps, microbumps, pillars, balls, and other forms such as C4 bumps, alone or in combination.

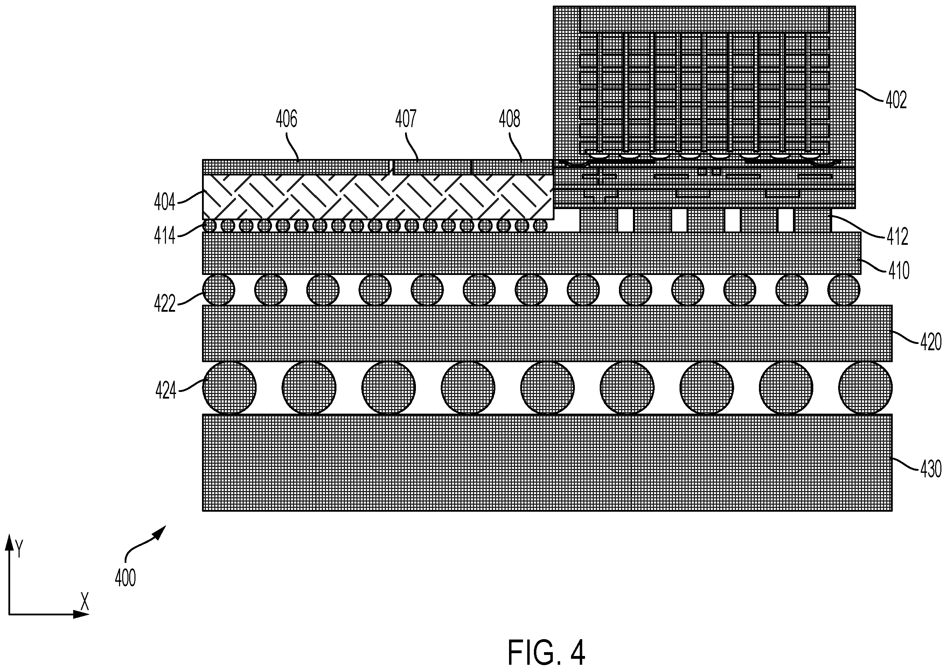

FIG. 4 depicts an exemplary embodiment of a product or card structure 400. The card structure 400 includes a packaged memory module 402 which may be any of the packaged memory structures shown herein, including the package architecture 100 and the package architecture 200 as shown in FIGS. 1A-2B. The first interconnects 412, which may include pads, microbumps and pillars, connect the packaged memory module 402 to an interposer 410. The interposer 410 may be formed from a substrate material such as silicon, as well as organic substrates. The interposer 410 may be in turn supporting an auxiliary processing unit 404 connected to the interposer via second interconnects 414, which may include pads, microbumps and pillars. Furthermore, the interposer 410 may be mounted on a packaging substrate 420 and connected to the packaging substrate 420 using third interconnects 422, which may include pads, bumps, pillars, and solder balls. The interposer 410 may include traces, vias, channels. lines, rails, and other structures either on or within the surface of the interposer providing an interconnecting system to connect the packaged memory module 402 to the auxiliary processing unit 404. The packaging substrate 420 may connect using fourth interconnects 424, such as solder balls, to a printed circuit board (PCB) 430. The PCB 430 is a multilayer board which may be a component within a larger computing system, for example, a graphics card.

The auxiliary processing unit 404 may provide additional processing for a device that the card structure 400 may be utilized in, and may include any suitable form of processing device including, for example, a GPU or a CPU, and may include a plurality of cores. In some embodiments, where the auxiliary processing unit 404 takes the form of a GPU, the auxiliary processing unit 404 may include a 3-D engine 406, a display controller 407, and may include an auxiliary controller 408. In some embodiments, where the packaged memory module 402 lacks a core die, the auxiliary controller 408 may take the form of a HBM controller. In some embodiments, the auxiliary controller 408 may be omitted or reassigned. In some embodiments, where the auxiliary processing unit 404 takes the form of a CPU, the auxiliary processing unit 404 may include a multi-core processor positioned close to the packaged memory module 402 such that latency may be decreased, and the effective storage capacity may be increased.

In some embodiments, a memory module mounted on the power and signal substrate may be thermally coupled to the power and signal substrate such that a thermal path is formed between the BSPDN layer and the memory module. In some embodiments, the thermal energy from the BSPDN may be dissipated by portions of the memory module. For example, in some embodiments, the memory module may include materials or structures to assist in dissipating heat, such as fins.

In some embodiments, a package architecture which integrates a chip using backside power delivery with stacked memory may monolithically integrate a memory module with a power and signal substrate including both a signal network layer and a BSPDN layer. In some embodiments, an integrated packaged memory structure may form a monolith where the memory module and power and signal substrate are closely integrated. A monolith may, among other advantages, reduce the size of routing distances, and thus a monolith may have decrease the voltage drop due to routing distances. A monolith may also provide increased power efficiency, reduced latency, and reduced routing congestion over a non-integrated form from the decreases in routing distances and higher density of devices.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device comprising:
a first layer including at least one transistor;
a second layer on a first side of the first layer, the second layer including a signal network;
a third layer on a second side of the first layer, the second side opposite the first side, the third layer including a backside power delivery network; and
a memory module coupled to the signal network.

2. The device of claim 1, wherein the memory module comprises at least one dynamic random-access memory die.

3. The device of claim 2, wherein the at least one dynamic random-access memory die comprises at least one core memory die.

4. The device of any one of claims 1 to 3, wherein the signal network is between the first layer and the memory module, and wherein the signal network communicatively couples the first layer and the memory module.

5. The device of any one of claims 1 to 4, further comprising a redistribution layer between the signal network and the memory module.

6. The device of claim 5, wherein the redistribution layer includes at least one through-bonding via.

7. The device of any one of claims 1 to 6, wherein the backside power delivery network is configured to provide power to the memory module.

8. The device of any one of claims 1 to 7, wherein the signal network is configured to provide packet routing signals to the memory module.

9. The device of any one of claims 1 to 8, wherein the backside power delivery network, the at least one transistor, and the signal network are configured to provide a logic circuit for the memory module.

10. The device of any one of claims 1 to 9, wherein:
the first layer comprises a substrate having a first side and a second side opposite the first side; and a transistor layer on the first side of the substrate, the transistor layer including the at least one transistor,
the signal network is on the transistor layer,
the signal network is communicatively coupled to the transistor layer,
the backside power delivery network is on the second side of the substrate,
the backside power delivery network is electrically coupled to the transistor layer, and
the backside power delivery network, the transistor layer, and the signal network are configured to provide a logic circuit for a memory module.

11. The device of claim 10, wherein the memory module comprises at least one high bandwidth memory die.

12. The device of claim 11, wherein the at least one high bandwidth memory die comprises at least one core memory die.

13. The device of claim 11 or 12, wherein the memory module is mounted on the substrate.
